Europäisches Patentamt

European Patent Office

Office européen des brevets

(19)

(11) Publication number: **0 268 401**
**A2**

(12)
# EUROPEAN PATENT APPLICATION

(21) Application number: 87309700.0

(22) Date of filing: 03.11.87

(51) Int. Cl.⁴: **G06F 11/00** , G11C 29/00

A request for addition of missing page 11 has been filed pursuant to Rule 88 EPC.

(30) Priority: 03.11.86 US 926620

(43) Date of publication of application:
**25.05.88 Bulletin 88/21**

(84) Designated Contracting States:
**DE FR GB**

(71) Applicant: **Hewlett-Packard Company**
**3000 Hanover Street**
**Palo Alto California 94304(US)**

(72) Inventor: **Eaton, Steven Glen**
**1755 Ednamary Way Nr. 4**
**Mountain View, CA 94040(US)**
Inventor: **Keshner, Marvin S.**
**321 East Street Nr. 2**
**Mountain View, CA 94043(US)**
Inventor: **Hanlon, Lawrence R.**
**287 Oakhurst Pl.**
**Menlo Park, CA 94043(US)**

(74) Representative: **Williams, John Francis et al**
**J.F. Williams & Co 34 Tavistock Street**
**London WC2E 7PB(GB)**

(54) Semiconductor memory systems and methods of operating them.

(57) A self-testing and self-repairing memory system (3-15) is presented as well as a method for using it and a method for making it. This memory system is constructed from memory chips (3-1 that have passed an abbreviated wafer probe test. After the memory system (3-15) is assembled, it tests itself to locate defective memory cells (3-5). The memory system (3-15) may decide to correct these defective memory cells (3-5) or it may decide to correct them using an error correction code engine (3-3). This memory system (3-15) tests itself during field use to locate defective memory cells. Once these defective memory cells (3-5) are located, the memory system (3-15) uses the error correction code engine (3-3) to correct these defective memory cells (3-5). When the error correction code engine (3-3) becomes overburdened with defective memory cells (3-5), then the memory system (3-15) replaces these defective memory cells (3-5).

FIG 3

# Semiconductor memory systems and methods of operating them

## Field of the Invention

The invention relates to computer semiconductor memories. More particularly, the invention relates to self-testing and self-repairing computer memory systems and a method for making and using them.

## Background of the Invention

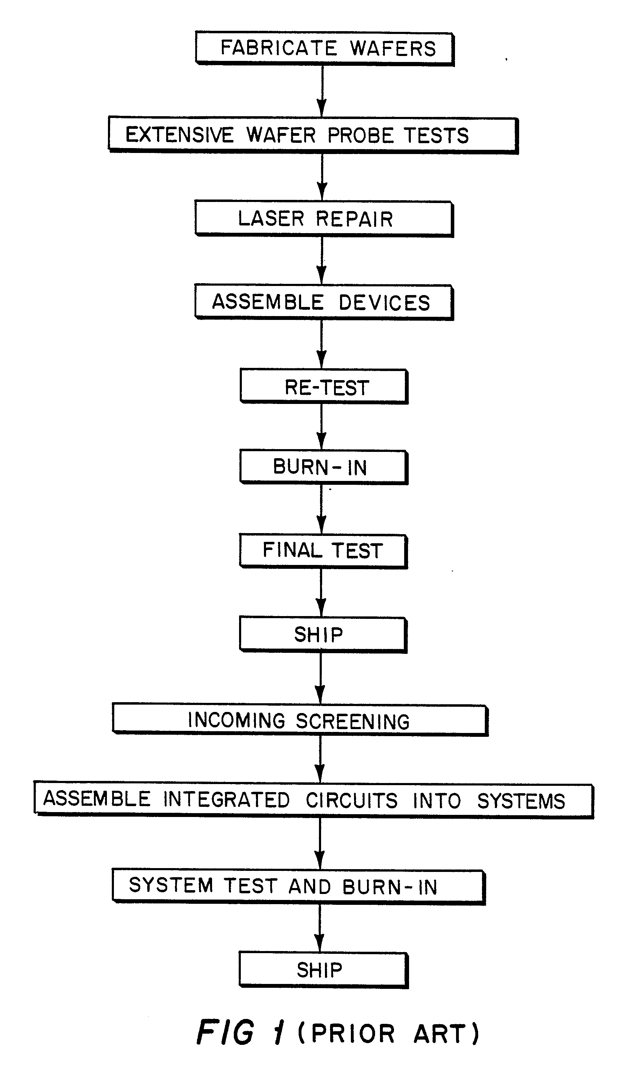

Figure 1 shows a prior-art method for testing and constructing dynamic RAM memories. After fabricating the wafers and before cutting them into individual chips the prior art conducts comprehensive wafer probe tests on the entire wafer. One such test is a D.C. fail test. This test measures the power supply current drawn by each die in active mode and standby mode. If a die draws too much current in either mode, the tester discards the die because the tester assumes the die has a short. Other wafer probe tests conducted on the individual cells, address decoders, and sense amplifiers determine their functionality.

After completion of the wafer probe tests, a laser repair procedure replaces defective memory cells with redundant rows and columns. If the number or placement of redundant rows and columns is not sufficient to repair the defective memory cells, the die is discarded. After completion of laser repair, the prior art retests the wafer. All failing die must be discarded because the prior-art procedures have no way to repair them.

After completing tests on the wafer, the wafer is diced into separate chips and assembled into separate packages. These packaged chips are tested for defects and then endure burn-in tests lasting approximately two days at elevated temperatures of 125°C. After passing the burn-in test, the devices encounter the manufacturer's final tests. These time-consuming, expensive tests include a pattern disturb test and write recovery test in addition to other tests. The chip manufacturer ships passing devices to customers who typically conduct the incoming screening tests on a sample of the devices. After installing these devices into memory systems, the customer tests the memory systems. These tests typically include a second burn-in test.

The testing and manufacturing procedures of the prior art have numerous disadvantages. Prior-art procedures use expensive equipment. The prior art handles the chips extensively and exposes them to electrostatic discharge and other hostile conditions that cause failures. Additionally, prior-art procedures inefficiently test for pattern sensitive defects. Pattern sensitive defects are memory defects that cause failures when the bits have a particular configuration. The prior art conducts tests for these pattern sensitive defects by storing every possible combination of ones and zeros into the memory. Obviously, this procedure is very time consuming if not impossible. Therefore, prior-art procedures miss some pattern sensitive defects. These undetected defects will cause system failures when they occur during field use.

Another disadvantage of prior-art testing and manufacturing procedures is the limited repair capability. The laser repair procedure of the prior art can only repair a small number of cell, column, or row defects. Additionally, the prior-art procedure can not repair defects found after the completion of the laser repair. Since the prior art conducts extensive tests after completing the laser repair procedure, this limitation is particularly troublesome.

The disadvantages discussed above increase the cost of manufacturing memory and decrease the yield of usable memory. Additionally, the disadvantages result in costly system failures. The methods and apparatus in accordance with the present invention aim to obviate these problems.

## Summary of the Invention

According to the invention, there is provided a method of operating a semiconductor memory system comprising the steps of performing, writing and reading operations to and from cells of the system in accordance with stored predetermined addresses which define the cells allocated to particular addresses; detecting any error in data read and determining the address from which it derived; and substituting for the cells pre-allocated to that address other cells of the memory system not otherwise allocated.

Further the invention proposes a semiconductor memory system comprising a plurality of memory cells, a system controller, an error detector and an address interpreter, wherein the error detector can detect errors in data retrieved from the memory cells, and the controller can cause substitution of a first memory address by a second in response to detection of a fault associated with the first address, so that thereafter the address interpreter employs the second address and the memory cells of the first address remain unused.

Preferably, the self-testing and self-repairing memory system contains memory cells that have passed an abbreviated wafer probe test, a system controller that coordinates testing and repairing, a rewritable table for storing the location of substitute memory cells, an address interpreter for obtaining the correct address and an error correction code engine (ECC engine) that corrects as well as detects errors.

According to the present invention, a method for making a self-testing and self-repairing memory system exploits the self-testing and self-repairing capability of the memory system. The method assemblies all the parts listed above. After assembly, the system controller conducts an initial self-test on the memory chips to determine the size and location of defects. The system controller determines whether to replace the defects or have the ECC engine correct the defects. Large groups of defective memory cells are typically replaced to avoid overburdening the error correction code engine. The system controller replaces defective memory cells by storing the addresses of the substitute memory cells and the defective memory cells into the rewritable table.

According to the present invention for the method of using the self-testing and self-repairing memory system detects, corrects, and repairs defective memory cells during normal operation. When the system is powered on, the system controller tests the memory system and replaces the larger groups of defects. When the power-on tests are completed, the error correction code engine begins its constant search for errors. The ECC engine corrects newly located defects, soft errors, and defects that the system controller decided not to replace. Meanwhile, the system controller monitors the number of defects and replaces the larger groups of defects.

Memory systems, according to the present invention, have several advantages which result in lower manufacturing cost and greater memory system reliability. First, instead of having expensive external equipment conduct tests on the memory systems, the memory systems, according to the present invention, can test themselves. This lowers testing costs during manufacture.

Second, memory systems, according to the present invention, require fewer tests during their manufacture. A memory system according to the present invention can repair defects at any time. Therefore, these memory systems delay most testing until the last step in the manufacturing process. Prior-art memory systems are repaired before the chips are passivated. Since this occurs early in the manufacturing process, the prior art must conduct two sets of tests. One set of tests searches for memory defects to repair before the chip is passivated. An additional set of tests must be conducted at the end of the manufacturing process to locate defects that have arisen since the first set of tests.

Third, memory systems, according to the present invention, correct pattern sensitive errors during field use of the memory system Prior-art memory systems can not correct the pattern sensitive defects during field use. Therefore, the prior-art memory systems must conduct extensive tests to locate these elusive defects. Tests for pattern sensitive defects are expensive and increase the cost of memory systems.

Fourth, memory systems, according to the present invention can detect and repair its own defects at any time. This advantage permits memory systems to use memory devices that have a few defects. In contrast, if a prior-art memory system has any defects after the laser repair step, that memory system must be discarded. This decreases the yields of prior art memory systems. Furthermore, if a prior-art memory system obtains a defect during field use, this defect will cause a system failure.

Finally, memory systems, according to the present invention, have increased reliability. Unlike the prior-art memory systems, they can recover from both hard and soft errors that occur during normal operation. In addition, it can detect the occurrence of new defects and determine the rate at which they occur. Based on this information, the memory system controller estimates future reliability of the memory system and reports this information to the host computer. If necessary, the system controller can request a service call.

Brief Description of the Drawings

Figure 1 shows the method for manufacturing prior art memory systems.

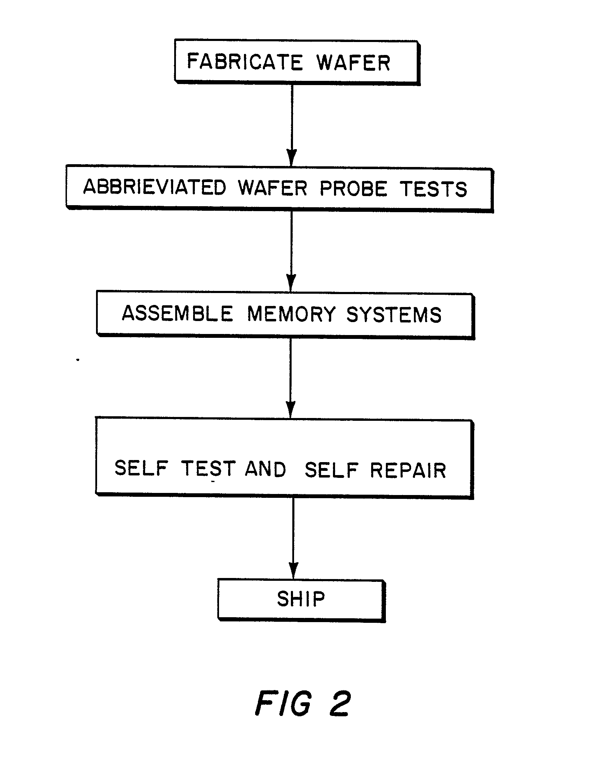

Figure 2 shows the present invention's method for manufacturing a self-testing and self-repairing memory system.

Figure 3 shows the preferred embodiment of the self-testing and self-repairing memory system apparatus.

Detailed Description of the Preferred Embodiment

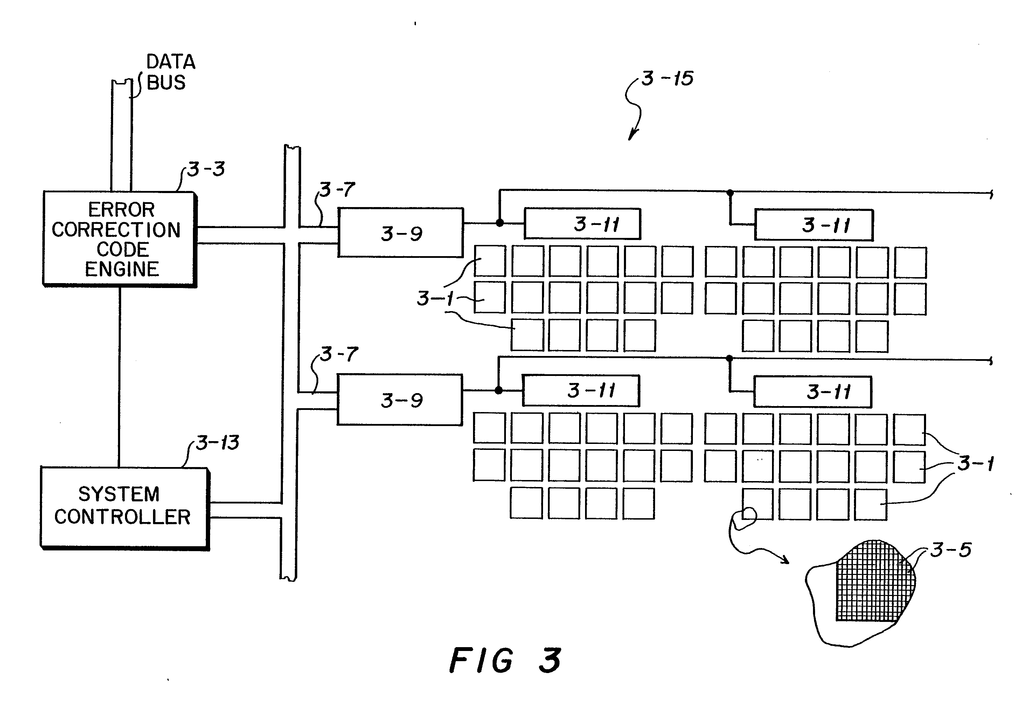

Figure 3 shows the preferred embodiment of the self-testing and self-repairing memory system. This memory system 3-15 contains memory chips 3-1 having numerous memory cells 3-5 that have passed an abbreviated wafer probe test, a system controller 3-13 with firmware that executes self-testing and self-repairing algorithms, a non-volatile table, a substitute address table 3-11 that is rewritable, an address interpreter 3-9, and an error correction code engine 3-3 that detects and corrects errors in the stored data.

The abbreviated wafer probe test detects chips requiring excessive operating current, requiring excessive standby current, or having an excessive number of nonfunctioning memory cells 3-5. These symptoms often result from defects in the power supply lines, address lines, and other gross failures. The manufacturer discards chips with gross defects and assembles the remaining chips into memory systems.

In the preferred embodiment of the invention, the acceptable chips 3-1 are assembled into clusters. Each cluster of the memory chips 3-1 has a substitute address table 3-11.

The clusters and their associated substitute address table 3-11 are divided into different channels 3-7. Each channel 3-7 has an address interpreter 3-9. Each memory system 3-15 contains a system controller 3-13 and an error correction code engine 3-3.

The preferred embodiment of the memory system 3-15 contains an address interpreter 3-9. The address interpreter 3-9 produces the address of substitute memory cell 3-5 when presented with the address of a replaced memory cell 3-5. Whenever the host computer system accesses a memory location, it sends the address to the address interpreter 3-9. The address interpreter 3-9 queries the substitute address table 3-11 to determine if that memory cell 3-5 has been replaced and to determine the address of that memory cell 3-5. The substitute address table 3-11 can have several different embodiments. It can be a look-up table which contains an entry for each memory location. Each address presented to a look-up table 3-11 addresses an unique entry in the look-up table 3-11. If the corresponding memory location has been replaced, the look-up table entry contains the address of the substitute memory cell 3-5. Alternatively, the substitute address table 3-11 can have the form of a content addressable memory. When the host computer system accesses memory, the memory address presented is compared with the entries in the content addressable memory 3-11. If the desired address does not match an entry of the content addressable memory (CAM) 3-11, then that particular memory location has not been replaced. If the address matches an entry of the content addressable memory, then that memory cell 3-5 has been replaced and the CAM produces the address of the substitute memory cell 3-5.

The substitute address table 3-11 stores pairs of addresses: the address of a defective group of memory cells 3-5 plus the address of a good group of memory cells 3-5 that replace the defective group of memory cells 3-5. When the memory system 3-15 receives a request to read or write data to a defective group of memory cells 3-5, the address interpreter 3-9 uses the substitute address table 3-11, to find the address of the substitute group of memory cells 3-5. Then, the memory system 3-15 sends the request to the substitute group of memory cells 3-1.

The substitute address table 3-11 is rewritable. Whenever defective memory cells 3-5 are detected, the memory system 3-15 can be repaired by updating the substitute address table 3-11 with an entry of the address of defective memory cells and the address of the substitute memory cells. Thus, the memory system 3-15 can repair itself at any time, either during manufacture or during normal operation.

The preferred embodiment of the memory system has an error correction code engine 3-3. The preferred embodiment of the invention uses the Reed-Solomon (255, 249) error correction code shortened to (70, 64). The error correction code breaks incoming data into records. Each record consists of 64 data bytes plus 6 bytes of check bits. From this data, the ECC engine 3-3 forms 70 symbols having 8 bits each and stores these symbols into memory. When the data is read from the memory system 3-15, it is passed through the ECC engine 3-3 which detects and corrects errors as long as the record does not contain too many defects. This particular Reed-Solomon error correction code can correct records containing fewer than four defective symbols. In order to operate the memory system 3-15 so that the combination of previously undetected defects combined with previously detected defects does not exceed the capability of the ECC engine 3-3, the preferred embodiment of the invention replaces defective memory cells 3-5 when the number of defective symbols per record exceeds one.

However, the invention could be practiced with larger records and/or a different margin of safety.

The present invention's method of making a self-testing and self-repairing memory system 3-15 uses the memory system's abilities to test and repair itself. The method conducts an abbreviated wafer probe test upon a wafer to detect and reject die that have gross defects such as excessive power supply current, defects in the address lines, power supply lines, or control logic. Unlike the prior art, the manufacturing process is then completed and the passing die are cut and packaged into chips 3-1 without repairing the die and without further testing. Next, the method assembles the chips into a memory system 3-15 with a system controller 3-13, substitute address table 3-11, address interpreter 3-9 and firmware to operate the system 3-15. Then, the entire memory system is subjected to burn-in tests.

Next, memory system 3-15 tests itself for defective memory cells 3-5 using firmware in the system controller 3-13. The firmware in the system controller 3-13 contains simple, short and inexpensive tests. These tests are an abbreviated version of tests conducted by conventional memory chip testers, such as a marching I's test. The system controller 3-13 conducts these tests by writing test patterns directly to the memory cells 3-5 and reading them back again.

After conducting the initial self-test, the memory system 3-15 decides how to repair the defective memory cells 3-5. The system controller 3-13 determines whether to correct the records containing defective cells with the error correction code engine 3-3 or to replace the records with a substitute group of memory cells 3-5. The system controller 3-13 replaces memory cell records having more defects than the error correction code engine 3-3 can handle with a wide margin of confidence. In the preferred embodiment, system controller 3-13 replaces memory cells 3-5 when the record contains more than one erroneous 8-bit symbol. The system controller 3-13 replaces these memory cells 3-5 in the manner stated previously. The system controller 3-13 updates the substitute address table 3-11 with the address of the defective memory cells 3-5 and the replacement memory cells 3-5.

The self-repairing feature of the memory system 3-15 allows the memory system 3-15 to delay self-testing until the memory system has been manufactured. The self-repair feature of the invention and the error correction code engine 3-3 allows the memory system 3-15 to use a simple test that allows a few defects to remain undetected and then to detect those defects during normal operation.

During normal operation, self-testing occurs under at least three conditions. In regular use, the self-testing and self-repairing memory system executes a simplified self-test with each power on. Secondly, the controlling computer system can request a self-test. Thirdly, during normal use, the self-testing and self-repairing memory system continually searches for errors by reading the data in every location at least once per day and by using the error correction code to detect errors. When an error is detected, the controller's 3-13 record of previously detected errors is consulted to determine if this is a newly detected defect. If it is a newly detected defect, the data is corrected by the ECC engine 3-3, rewritten and reread to determine if it is a hard or soft error. If it is a hard error, and the number of defective symbols in that record is still acceptable, then the corresponding group of memory cells 3-5 remains in use. However, if the number of defective symbols exceeds the criterion for acceptable ECC engine 3-3 margin, then that defective group of memory cells 3-5 is taken out of use. A substitute group of memory cells 3-5 are used instead; the substitute address table 3-11 is updated and the corrected data is written into the substitute location. The addresses of the group of memory cells 3-1 that contain too many defective cells are stored in the substitute address table 3-11 along with the address of a good group of memory cells 3-5 that will be used instead.

The present invention's method of using the self-testing and self-repairing memory system 3-15 tests and repairs the system 3-15 at power on, corrects soft errors and memory defects that were not replaced by good memory cells 3-5, searches for new or previously undetected errors, and records errors detected by the error correction code engine 3-3, and uses these records to estimate the memory system's 3-15 reliability.

When the power is turned on, the system 3-15 self-tests and self-repairs. The memory system 3-15 updates the substitute address table 3-11 for any groups of memory cells 3-5 that are defective. Also, it reports its usable capacity to the host computer system and answers requests for reliability data.

During normal use, when the host system requests the memory system 3-15 to write data to a particular address, the error correction code engine 3-13 encodes the data. The address interpreter 3-9 searches the substitute address table 3-11 for that address specified by the host. If the address is found, the data is written instead into the substitute address. Otherwise, the data is written into the address specified by the host. When the host requests that data be read from a particular address, again the address interpreter 3-9 causes the memory system to read from the substitute address if the address specified by the host is defective.

Those few defective cells 3-5 that were not detected during the self-test, whose failure depends on the pattern of data in the surrounding cells, are detected during normal use. The pattern sensitive defects are detected as errors in the data by the error correction code engine 3-3.

When the number of defective cells in a group of memory cells 3-5 approaches the maximum number of defects that can be corrected by the error correction code engine 3-3, then the group is termed defective. When a group is newly termed defective, the substitute address table 3-11 is updated with the addresses of the defective group and of the substitute good group of memory cells 3-5, then the data is corrected by the error correction code engine 3-3 and restored into the substitute group of good memory cells 3-5. If the newly detected defective cell does not increase the number of defects present in a group of memory cells 3-5 to the point where it approaches the ability of the error correction code engine 1-3 to correct the data, then the group of memory cells 3-1 is not termed defective and remains in use. No substitute is assigned, and the substitute address table 3-11 is not changed. The next time data is read from this group of memory cells 3-5, the defective cell 3-5 will be detected again and the data will be corrected by the error correction code engine 3-3.

The data that is read from either the host specified address or the substitute address is processed by the error correction engine 3-3. If errors are detected, they are corrected, and the system controller 3-13 is notified that errors have occurred. The system controller 3-13 compares the address to its record of addresses with defective cells and updates this record if necessary. If the number of defective cells is approaching the maximum number of errors that can be corrected by the error correction code engine 3-3, then the system controller 3-13 declares that address to be defective. It takes the corrected data, writes it into a group of good memory cells 3-5 at an unused address, and then adds an entry to the substitute address table 3-11.

System reliability can be estimated from the number and rate of defects that are detected while the system is in operation. Hard errors defined as permanent failures can be distinguished from transient errors (soft errors) by comparing the recent report of errors from the error correction code with the error report stored in the controller's record.

Since undetected defects are few in number, the probability that previously undetected defects might combine with previously detected defects and together exceed the maximum number of errors that the error correction code engine 3-3 can correct is extremely small. Therefore, the presence of these heretofore undetected defects, and the data errors they cause, do not cause uncorrectable errors that would cause a memory system 3-15 failure.

A second special case occurs when a record is found with an uncorrectable error in it. In that case, the system controller 3-13 would save the uncorrected data and check bits and test the offending record. If the record was found to be defective, it would be spared and the uncorrected record and the check bits would be written back into the spare. A note would be made that uncorrectable data had been intentionally stored in that location. If the controlling computer ever read that record, it would be given the uncorrected data and a flag indicating bad data.

## Claims

1. A method of operating a semiconductor memory system comprising the steps of performing, writing and reading operations to an from cells of the system in accordance with stored predetermined addresses which define the cells allocated to particular addresses; detecting any error in data read and determining the address from which it derived; and substituting for the cells pre-allocated to that address other cells of the memory system not otherwise allocated.

2. A method as claimed in claim 1 wherein errors are detected during normal use of the memory system.

3. A method as claimed in claim 1 or 2 wherein the system includes a controller which causes writing and reading operation to be repeatedly performed successively through all memory cells of the system.

4. A method as claimed in any preceding claim wherein the number of errors detected and/or the number of cells taken out of use is monitored, and a warning signal produced when said number exceeds a certain threshold.

5. A semiconductor memory system comprising a plurality of memory cells (3-5), a system controller (3-13), an error detector (3-3) and an address interpreter (3-9), wherein the error detector (3-3) can detect errors in data retrieved from the memory cells (3-5), and the controller (3-13) can cause substitution of a first memory address by a second in response to detection of a fault associated with the first address, so that thereafter the address interpreter (3-9) employs the second address and the memory cells of the first address remain unused.

6. A memory system as claimed in claim 5 wherein said address interpreter (3-9) has or is associated with at least one memory which retains details of substituted addresses.

7. A memory system as claimed in claim 6 wherein said one memory contains only those original addresses which have been changed, together with the substitute addresses.

8. A method of making a memory system (3-15) comprising the steps:
assembling a plurality of memory cells (3-5);
connecting a self-testing means for testing said memory cells (3-5) and for identifying defective memory cells (3-5);
connecting a replacing means responsive to said self-testing means for replacing said defective memory cells (3-5); and
connecting a controlling means to said self-testing means and said replacement means for controlling the replacement of defective memory cells (3-5).

9. A method of making a memory system as in claim 8 wherein connecting a self-testing means further comprises:

connecting a first detecting means for detecting said defective memory cells (3-5) after assembly of said memory system (3-15); and

connecting a second detecting means for detecting said defective memory cells (3-5) during field use of said memory system (3-15).

10. A semiconductor memory system (3-15) comprising:

a plurality of memory cells (3-5);

a first detecting means connected to said memory cells (3-5) for detecting defective memory cells (3-5);

a first replacing means responsive to said first detecting means for replacing said defective memory cells (3-5); and

a controlling means (3-13) connected to said first detecting means and said first replacing means for controlling the replacement of defective memory cells (3-5).

11. An apparatus as in claim 10 wherein said first detecting means further comprises:

a second detecting means for detecting said defective memory cells (3-5) after said memory system (3-15) is assembled; and

a third detecting means (3-3) for detecting said defective memory cells (3-5) during field use of said memory system (3-15).

```
┌─────────────────────────┐
│    FABRICATE WAFERS     │
└─────────────────────────┘
             │
             ▼
┌─────────────────────────────────┐
│   EXTENSIVE WAFER PROBE TESTS    │
└─────────────────────────────────┘
             │
             ▼
┌─────────────────────────┐
│      LASER REPAIR       │
└─────────────────────────┘
             │
             ▼
┌─────────────────────────┐
│    ASSEMBLE  DEVICES    │
└─────────────────────────┘
             │
             ▼
┌─────────────────────────┐
│        RE-TEST          │
└─────────────────────────┘
             │
             ▼
┌─────────────────────────┐
│       BURN - IN         │
└─────────────────────────┘
             │
             ▼
┌─────────────────────────┐
│       FINAL TEST        │
└─────────────────────────┘
             │
             ▼
┌─────────────────────────┐
│         SHIP            │
└─────────────────────────┘
             │
             ▼
┌─────────────────────────────────┐
│      INCOMING SCREENING         │
└─────────────────────────────────┘
             │
             ▼
┌─────────────────────────────────────────────┐
│  ASSEMBLE INTEGRATED  CIRCUITS  INTO  SYSTEMS │
└─────────────────────────────────────────────┘
             │
             ▼
┌─────────────────────────────────┐
│   SYSTEM TEST AND BURN-IN        │
└─────────────────────────────────┘
             │
             ▼
┌─────────────────────────┐
│         SHIP            │
└─────────────────────────┘
```

*FIG 1* (PRIOR ART)

```
                    ┌─────────────────────┐
                    │   FABRICATE WAFER   │
                    └─────────────────────┘
                               │
                               ▼
          ┌──────────────────────────────────────┐
          │   ABBRIEVIATED WAFER PROBE TESTS      │
          └──────────────────────────────────────┘
                               │
                               ▼
          ┌──────────────────────────────────────┐
          │      ASSEMBLE  MEMORY SYSTEMS         │
          └──────────────────────────────────────┘
                               │
                               ▼
          ┌──────────────────────────────────────┐
          │                                      │
          │   SELF TEST AND  SELF REPAIR         │
          │                                      │
          └──────────────────────────────────────┘
                               │
                               ▼
                    ┌─────────────────────┐
                    │        SHIP         │
                    └─────────────────────┘
```

*FIG 2*

FIG 3